# EUROPEAN PATENT APPLICATION

(11) **EP 4 832 701 A1**
(43) Date of publication of application: **28.10.2026**
(21) Application number: 25917339.1
(22) Date of filing: 30.06.2025
(51) Int. Cl.: H10H 20/841, H10H 20/831, H10H 20/815, H10H 20/816, H10H 20/857, H10H 29/14

(54) **LED CHIP, HIGH-VOLTAGE LED CHIP AND LIGHT-EMITTING DEVICE**

(30) Priority: 07.03.2025 CN 202510270268; 07.03.2025 CN 202520395462 U
(71) Applicant: Xiamen Changelight Co., Ltd., Xiamen, Fujian 361000 (CN)
(72) Inventor: CHEN, Shuaicheng, Xiamen, Fujian 361000 (CN); YE, Lingna, Xiamen, Fujian 361000 (CN); YANG, Deyou, Xiamen, Fujian 361000 (CN); WU, Xingen, Xiamen, Fujian 361000 (CN); FEI, Yunrui, Xiamen, Fujian 361000 (CN); ZHANG, Jiahong, Xiamen, Fujian 361000 (CN); HE, Jian, Xiamen, Fujian 361000 (CN)
(74) Representative: Michalski Hüttermann & Partner mbB
(86) International application number: PCT/CN2025/105600
(87) International publication number: WO 2026/183996

(57) **Abstract**

One or more embodiments of the present disclosure provide a LED chip, a high-voltage LED chip, and a light-emitting device. By disposing the first insulating layer on the light-emitting mesa such that the first insulating layer, the transparent conductive layer, the second insulating layer, and the second electrode have a composite region, an ODR structure is formed. Light can undergo total internal reflection in this composite region, so that light corresponding to the composite region under the second electrode is reflected and extracted from the upper surface of the LED chip, thereby effectively enhancing light extraction efficiency. Simultaneously, since the second insulating layer is disposed on the surface of the epitaxial stack and on portions of the surfaces of the second electrode/first electrode, at the edge of the second electrode the first insulating layer and the second insulating layer extending in different directions can form a connecting structure with an angle, effectively alleviating the diffusion of tensile stress generated in the LED chip under special environments and reducing the risk of functional dielectric layers being damaged or cracked, which would affect the reliability of the LED chip; and the dual protection provided by the first insulating layer and the second insulating layer enhances the moisture resistance of the LED chip.

## Description

### CROSS-REFERENCE TO RELATED APPLICATIONS

This application claims priority to Chinese Patent Application No. 202510270268.5, filed on March 7, 2025, and Chinese Patent Application No. 202520395462.1, also filed on March 7, 2025, each entitled "LED Chip, High-Voltage LED Chip, and Light-Emitting Device," the entire contents of each of which are incorporated herein by reference.

### TECHNICAL FIELD

The present disclosure relates to the field of LED chips, and in particular to an LED chip, a high-voltage LED chip, and a light-emitting device.

### BACKGROUND

Light-emitting diodes (LEDs) have advantages such as high efficiency, long service life, small size, and low power consumption, and are widely used in indoor and outdoor white-light illumination, display panels, backlight sources, and other applications. A LED chip functions to convert electrical energy into light energy, and typically includes an epitaxial wafer and an N-type electrode and a P-type electrode respectively disposed on the epitaxial wafer. The epitaxial wafer includes a P-type semiconductor layer, an N-type semiconductor layer, and an active layer disposed between the N-type semiconductor layer and the P-type semiconductor layer. When current flows through the LED chip, holes in the P-type semiconductor layer and electrons in the N-type semiconductor layer migrate toward the active layer and recombine therein, thereby causing the LED chip to emit light.

As the LED application market-particularly display applications-continues to expand, higher requirements have been imposed by LED packaging manufacturers on the light extraction efficiency and reliability of LED chips in order to ensure application performance. At present, although the internal quantum efficiency of most LED chips has approached approximately 99%, their light extraction efficiency remains generally low. The primary reasons include: (1) severe total internal reflection occurring inside the LED chip, which results in only a small portion of the light generated in the light-emitting layer being extracted; and (2) current crowding effects, which lead to reduced luminous efficiency of the LED chip.

With respect to reliability issues of LED chips, the primary factors include: (1) a relatively large number of functional dielectric layers disposed beneath a P-electrode pad region, such as a current blocking layer (also commonly referred to in the art as a CB layer) and a transparent conductive layer (also commonly referred to as an ITO layer). Such a structure increases the risk that the functional dielectric layers at the contact region may be damaged or cracked during soldering, thereby adversely affecting the reliability of the LED chip; and (2) during actual operation, moisture ingress may cause micro short-circuits under reverse-bias conditions, ultimately leading to burnout or failure of the LED chip, which significantly degrades reliability in practical applications and limits broader use. Accordingly, how to improve light extraction efficiency and reliability of LED chips without degrading optoelectronic performance has become an urgent technical problem to be addressed.

### SUMMARY

One or more embodiments of the present disclosure provide a LED chip, a high-voltage LED chip, and a light-emitting device, so as to address the technical problems of low luminous efficiency and poor reliability of LED chips in the prior art.

According to a first aspect of the present disclosure, one or more embodiments provide a LED chip. The LED chip includes a substrate and a plurality of LED light-emitting units disposed on a surface of the substrate and isolated from one another by trenches, wherein each LED light-emitting unit includes:
an epitaxial stack disposed on the surface of the substrate, the epitaxial stack including, in sequence along a first direction, a first conductivity-type semiconductor layer, an active region, and a second conductivity-type semiconductor layer, wherein a local region of the epitaxial stack is etched at least to the first conductivity-type semiconductor layer to define a recess and a light-emitting mesa, and wherein the first direction is perpendicular to the surface of the substrate and extends from the substrate toward the epitaxial stack;
a transparent conductive layer disposed on the light-emitting mesa and having a second opening exposing a portion of the second conductivity-type semiconductor layer;
a first insulating layer disposed on a surface of the transparent conductive layer opposite to the epitaxial stack;
a first electrode disposed on a portion of a surface of the recess and spaced apart from the light-emitting mesa;
a second electrode extending through the second opening to contact a portion of a surface of the first insulating layer; and
a second insulating layer disposed on a surface of the epitaxial stack and exposing at least portions of surfaces of the second electrode and the first electrode.

Preferably, the first insulating layer exposes a portion of the transparent conductive layer to form a step, and the second electrode extends to the surface of the first insulating layer via the step.

Preferably, a projection of the second electrode on the transparent conductive layer and a projection of the second electrode on the first insulating layer have an overlapping region with an area Sa, and a projection area of the second electrode on the transparent conductive layer is S1, such that 0<Sa≤S1/2.

Preferably, the step is disposed around an edge of the second opening.

Preferably, a current blocking layer is disposed on a bottom surface of the second opening.

Preferably, the current blocking layer and the transparent conductive layer form a spacing groove, and the second electrode is embedded in the spacing groove to contact the second conductivity-type semiconductor layer.

Preferably, a projection area of the current blocking layer on the transparent conductive layer is S2, and a bottom surface area of the second opening is S3, such that 0<S2≤S3/2.

Preferably, the first insulating layer and the current blocking layer are formed simultaneously by photolithography of a transparent dielectric layer.

In one or more embodiments, the transparent dielectric layer includes one or more of silicon oxide, silicon nitride, aluminum oxide, and magnesium fluoride.

Preferably, a third insulating layer is further disposed on a surface of the recess, the third insulating layer having a first opening exposing a portion of the first conductivity-type semiconductor layer, and the first electrode is stacked on a surface of the third insulating layer by being embedded in the first opening.

Preferably, the first insulating layer and the third insulating layer are formed simultaneously by photolithography of a transparent dielectric layer.

Preferably, the LED chip further includes a refractive-index matching layer disposed on a surface of the second insulating layer opposite to the epitaxial stack and forming a graded-index structure with the second insulating layer, further enhancing light extraction efficiency. In one or more embodiments, a refractive index of the refractive-index matching layer is not less than a refractive index of the second insulating layer. Further, the first insulating layer or the second insulating layer may include a layered structure composed of one or more of SiO₂ and MgF₂, and the refractive-index matching layer may include a layered structure composed of one or more of TiO₂, Si₃N₄, and Al₂O₃. In one or more embodiments, the second insulating layer is a SiO₂ layer, and the refractive-index matching layer is an Al₂O₃ layer. Benefiting from the excellent passivation properties of Al₂O₃, it can effectively cover dangling bonds and defect states on the SiO₂ surface, reducing non-radiative recombination of carriers at the surface. The reduction in non-radiative recombination directly improves the internal quantum efficiency (IQE), meaning more electrical energy is converted into light energy rather than heat.

Preferably, a reflective layer is further disposed on a surface of the substrate opposite to the epitaxial stack. Further, the reflective layer includes a distributed Bragg reflector (DBR) composed of alternating stacks of high-refractive-index material layers and low-refractive-index material layers. Alternatively, the reflective layer may also be a metal reflective layer.

Preferably, the first electrode includes a first electrode pad disposed at a first end of the LED chip. The second opening is formed at a second end of the LED chip. The second electrode includes a second electrode pad and at least one electrode extension strip connected to the second electrode pad, wherein the second electrode pad extends through the second opening to contact a top surface of the first insulating layer, and the electrode extension strip extends from the second electrode pad toward the second end of the LED chip.

Further, the first electrode may also include an electrode extension strip connected to the first electrode pad and extending toward the first end.

Preferably, at least a portion of the electrode extension strip of the second electrode is in contact with the transparent conductive layer.

Preferably, the electrode extension strip has a forked structure, and the forked structure contacts the transparent conductive layer by penetrating through the first insulating layer. Alternatively, the transparent conductive layer has through-holes, and the electrode extension strip has forked fingers, the forked fingers being formed and held in the through-holes of the transparent conductive layer.

Preferably, the second insulating layer covers the light-emitting mesa and the recess while being retained on an exposed surface of the first conductivity-type semiconductor layer.

Preferably, the transparent conductive layer covers at least 80% of the area of the light-emitting mesa excluding the second opening.

Preferably, the second electrode has a metal reflective layer.

Preferably, a bottom layer of the second electrode is the metal reflective layer.

Preferably, the metal reflective layer includes one or more of Ag, Ni, Al, Rh, Pd, Ir, Ru, Mg, Zn, Pt, and Au.

According to a second aspect of the present disclosure, one or more embodiments provide a high-voltage LED chip. The high-voltage LED chip electrically interconnects adjacent LED light-emitting units according to any one of the above embodiments via bridging electrodes. An insulating layer is further disposed in the trenches, and the bridging electrode connects two adjacent LED light-emitting units by being stacked on the insulating layer.

According to a third aspect of the present disclosure, one or more embodiments provide a light-emitting device. The light-emitting device includes a light-emitting diode employing the LED chip according to any one of the above embodiments.

According to a fourth aspect of the present disclosure, one or more embodiments provide a light-emitting device. The light-emitting device includes a light-emitting diode employing the high-voltage LED chip according to the second aspect of the present disclosure.

According to the LED chip provided by embodiments of the present disclosure, by arranging: the epitaxial stack including the first conductivity-type semiconductor layer, the active region, and the second conductivity-type semiconductor layer stacked in sequence along the first direction; the local region of the epitaxial stack being etched at least to the first conductivity-type semiconductor layer to form the recess and the light-emitting mesa; the transparent conductive layer being stacked on the light-emitting mesa and having the second opening exposing a portion of the second conductivity-type semiconductor layer; the first insulating layer being formed on the surface of the transparent conductive layer opposite to the epitaxial stack; the first electrode being stacked on a portion of the surface of the recess and spaced apart from the light-emitting mesa; the second electrode extending through the second opening to contact a portion of the surface of the first insulating layer; and the second insulating layer being disposed on the surface of the epitaxial stack and exposing at least portions of the surfaces of the second electrode and the first electrode - a composite region is formed among the first insulating layer, the transparent conductive layer, the second insulating layer, and the second electrode. Thereby, an ODR structure is formed through the inter-structural relationships among the transparent conductive layer, the first insulating layer, the second electrode, and the second insulating layer. Light can undergo total internal reflection in this composite region, so that light corresponding to the composite region under the second electrode is reflected and extracted from the upper surface of the LED chip, thereby effectively enhancing light extraction efficiency. Simultaneously, since the second insulating layer is disposed on the surface of the epitaxial stack and on portions of the surfaces of the second electrode/first electrode, at the edge of the second electrode the first insulating layer and the second insulating layer extending in different directions can form a connecting structure with an angle. This can effectively alleviate the diffusion of tensile stress generated in the LED chip under special environments (such as high temperature and high pressure), thereby reducing the risk of functional dielectric layers (such as the transparent conductive layer, insulating layers, etc.) being damaged or cracked during bonding, which would affect the reliability of the LED chip. Moreover, the dual protection provided by the first insulating layer and the second insulating layer enhances the moisture resistance capability of the LED chip.

By further arranging the first insulating layer to expose a portion of the transparent conductive layer to form a step, and the second electrode extending to the surface of the first insulating layer via the step: the electrode contact area is increased through the step, thereby dispersing stress and reducing the risk of local failure.

By arranging that a projection of the second electrode on the transparent conductive layer and a projection of the second electrode on the first insulating layer have an overlapping region with an area Sa, and a projection area of the second electrode on the transparent conductive layer is S1, such that 0<Sa≤S1/2: the contact area between the second electrode and the transparent conductive layer is ensured to reduce contact resistance, while the size of the composite region area is ensured to improve the ODR reflection effect.

By further arranging a current blocking layer on a bottom surface of the second opening, wherein the current blocking layer and the transparent conductive layer form a spacing groove and the second electrode is embedded in the spacing groove to contact the second conductivity-type semiconductor layer: current crowding is improved and lateral current spreading is promoted; simultaneously, the inter-structural relationships among the second electrode, the first insulating layer (dielectric layer), the spacing groove, the current blocking layer (dielectric layer), and the transparent conductive layer (conductive layer) again form an ODR structure, which is beneficial for increasing the area of the total reflection layer under the electrode, further enhancing reflection efficiency. By further arranging that a projection area of the current blocking layer on the transparent conductive layer is S2, and a bottom surface area of the second opening is S3, such that 0<S2≤S3/2: while ensuring current blocking and total reflection effects, the contact area between the second electrode and the second conductivity-type semiconductor layer is ensured to improve the reliability of electrode wire bonding.

By further arranging that the first electrode includes a first electrode pad disposed at a first end of the LED chip, the second opening being formed at a second end of the LED chip, and the second electrode including a second electrode pad and at least one electrode extension strip connected to the second electrode pad, wherein the second electrode pad extends through the second opening to contact a top surface of the first insulating layer and the electrode extension strip extends from the second electrode pad toward the second end of the LED chip: current can be better guided and spread through the electrode extension strip, avoiding current crowding.

### BRIEF DESCRIPTION OF THE DRAWINGS

In order to more clearly illustrate the technical solutions of the embodiments of the present disclosure or the prior art, the drawings required in the description of the embodiments or the prior art are briefly described below. The drawings described below are merely embodiments of the present disclosure, and a person of ordinary skill in the art may obtain other drawings based on these drawings.
FIG. 1 is a schematic cross-sectional structural view of a LED chip provided according to one or more embodiments of the present disclosure (Embodiment 1).
FIGS. 2 through 10 are schematic structural views corresponding to respective steps of a method for manufacturing the LED chip according to Embodiment 2 of the present disclosure.
FIG. 11 is a schematic cross-sectional structural view of a LED chip provided according to Embodiment 3 of the present disclosure.
FIG. 12 is a schematic cross-sectional structural view of a LED chip provided according to Embodiment 4 of the present disclosure.
FIG. 12-1 is a schematic cross-sectional structural view of a LED chip provided according to Embodiment 4-1 of the present disclosure.
FIG. 13 is a schematic cross-sectional structural view of a LED chip provided according to Embodiment 5 of the present disclosure.
FIG. 14 is a schematic cross-sectional structural view of a LED chip provided according to Embodiment 6 of the present disclosure.
FIG. 15 is a schematic cross-sectional structural view of a LED chip provided according to Embodiment 7 of the present disclosure.
FIG. 16 is a schematic cross-sectional structural view of a LED chip provided according to Embodiment 8 of the present disclosure.

Reference numerals: 1, substrate; 2, first conductivity-type semiconductor layer; 3, active region; 4, second conductivity-type semiconductor layer; 5, transparent conductive layer; 5.1, second opening; 6, first insulating layer; 7, second electrode; 8, first electrode; 9, second insulating layer; 10, recess; 11, light-emitting mesa; 12, third insulating layer, 12.1, first opening; 13, current blocking layer; 14, electrode extension strip; 15, refractive-index matching layer; 16, reflective layer; 17, trench.

### DETAILED DESCRIPTION

To make the content of the present disclosure clearer, the content of the present disclosure is further explained below in conjunction with the accompanying drawings. The scope of the present disclosure is not limited to the specific embodiments. Based on the embodiments of the present disclosure, all other embodiments obtained by those of ordinary skill in the art without inventive effort shall fall within the scope of protection of the present disclosure.

A LED chip includes a substrate and a plurality of LED light-emitting units disposed on a surface of the substrate and isolated from one another by trenches, wherein each LED light-emitting unit includes:
an epitaxial stack disposed on the surface of the substrate, the epitaxial stack including, in sequence along a first direction, a first conductivity-type semiconductor layer, an active region, and a second conductivity-type semiconductor layer, wherein a local region of the epitaxial stack is etched at least to the first conductivity-type semiconductor layer to define a recess and a light-emitting mesa, and wherein the first direction is perpendicular to the surface of the substrate and extends from the substrate toward the epitaxial stack;
a transparent conductive layer disposed on the light-emitting mesa and having a second opening exposing a portion of the second conductivity-type semiconductor layer;
a first insulating layer disposed on a surface of the transparent conductive layer opposite to the epitaxial stack;
a first electrode disposed on a portion of a surface of the recess and spaced apart from the light-emitting mesa;
a second electrode extending through the second opening to contact a portion of a surface of the first insulating layer; and
a second insulating layer disposed on a surface of the epitaxial stack and exposing at least portions of surfaces of the second electrode and the first electrode. Further, the second insulating layer covers the light-emitting mesa and the recess and exposes portions of the surfaces of the second electrode and the first electrode.

The type of substrate is not limited in the LED chip of this embodiment. For example, the substrate may be, but is not limited to, a sapphire substrate, a silicon substrate, or the like. Additionally, the types of the first conductivity-type semiconductor layer, the active region, and the second conductivity-type semiconductor layer of the epitaxial stack are also not limited in the LED chip of this embodiment. In embodiments of the present disclosure, the first conductivity-type semiconductor layer may be an N-type semiconductor layer, and correspondingly, the second conductivity-type semiconductor layer may be a P-type semiconductor layer. For instance, the first conductivity-type semiconductor layer may be, but is not limited to, an N-type gallium nitride layer, and correspondingly, the second conductivity-type semiconductor layer may be, but is not limited to, a P-type gallium nitride layer.

In order to highlight the technical features of the present disclosure, the drawings schematically show only one epitaxial stack unit. In practical product applications, it may include thousands or tens of thousands of epitaxial stack units, depending on the application of the LED chip product, which is not limited herein.

In one or more embodiments of the present disclosure, the first insulating layer exposes a portion of the transparent conductive layer to form a step, and the second electrode extends to the surface of the first insulating layer via the step.

In one or more embodiments of the present disclosure, a projection of the second electrode on the transparent conductive layer and a projection of the second electrode on the first insulating layer have an overlapping region with an area Sa, and a projection area of the second electrode on the transparent conductive layer is S1, such that 0<Sa≤S1/2.

In one or more embodiments of the present disclosure, the step is disposed around an edge of the second opening.

In one or more embodiments of the present disclosure, a current blocking layer is disposed on a bottom surface of the second opening.

In one or more embodiments of the present disclosure, the current blocking layer and the transparent conductive layer form a spacing groove, and the second electrode is embedded in the spacing groove to contact the second conductivity-type semiconductor layer.

In one or more embodiments of the present disclosure, a projection area of the current blocking layer on the transparent conductive layer is S2, and a bottom surface area of the second opening is S3, such that 0<S2≤S3/2.

In one or more embodiments of the present disclosure, the first insulating layer and the current blocking layer are formed simultaneously by photolithography of a transparent dielectric layer. In one or more embodiments of the present disclosure, the transparent dielectric layer includes one or more of silicon oxide, silicon nitride, aluminum oxide, and magnesium fluoride.

In one or more embodiments of the present disclosure, a third insulating layer is further disposed on a surface of the recess, the third insulating layer having a first opening exposing a portion of the first conductivity-type semiconductor layer, and the first electrode is stacked on a surface of the third insulating layer by being embedded in the first opening.

In one or more embodiments of the present disclosure, the first insulating layer and the third insulating layer are formed simultaneously by photolithography of a transparent dielectric layer. In one or more embodiments of the present disclosure, the LED chip further includes a refractive-index matching layer disposed on a surface of the second insulating layer opposite to the epitaxial stack and forming a graded-index structure with the second insulating layer, further enhancing light extraction efficiency. In one or more embodiments, a refractive index of the refractive-index matching layer is not less than a refractive index of the second insulating layer. Further, the first insulating layer or the second insulating layer may include a layered structure composed of one or more of SiO₂ and MgF₂, and the refractive-index matching layer may include a layered structure composed of one or more of TiO₂, Si₃N₄, and Al₂O₃. In one or more embodiments of the present disclosure, the second insulating layer is a SiO₂ layer, and the refractive-index matching layer is an Al₂O₃ layer. Benefiting from the excellent passivation properties of Al₂O₃, it can effectively cover dangling bonds and defect states on the SiO₂ surface, reducing non-radiative recombination of carriers at the surface. The reduction in non-radiative recombination directly improves the internal quantum efficiency (IQE), meaning more electrical energy is converted into light energy rather than heat.

In one or more embodiments of the present disclosure, a reflective layer is further disposed on a surface of the substrate opposite to the epitaxial stack. Further, the reflective layer includes a distributed Bragg reflector (DBR) composed of alternating stacks of high-refractive-index material layers and low-refractive-index material layers. Alternatively, the reflective layer may also be a metal reflective layer.

In one or more embodiments of the present disclosure, the first electrode includes a first electrode pad disposed at a first end of the LED chip. The second opening is formed at a second end of the LED chip. The second electrode includes a second electrode pad and at least one electrode extension strip connected to the second electrode pad, wherein the second electrode pad extends through the second opening to contact a top surface of the first insulating layer, and the electrode extension strip extends from the second electrode pad toward the second end of the LED chip.

In one or more embodiments of the present disclosure, the first electrode may also include an electrode extension strip connected to the first electrode pad and extending toward the first end. In one or more embodiments of the present disclosure, at least a portion of the electrode extension strip is in contact with the transparent conductive layer.

In one or more embodiments of the present disclosure, the electrode extension strip has a forked structure, and the forked structure contacts the transparent conductive layer by penetrating through the first insulating layer. Alternatively, the transparent conductive layer has through-holes, and the electrode extension strip has forked fingers, the forked fingers being formed and held in the through-holes of the transparent conductive layer.

In one or more embodiments of the present disclosure, the second insulating layer covers the light-emitting mesa and the recess while being retained on an exposed surface of the first conductivity-type semiconductor layer.

In one or more embodiments of the present disclosure, the transparent conductive layer covers at least 80% of the area of the light-emitting mesa excluding the second opening.

In one or more embodiments of the present disclosure, the second electrode has a metal reflective layer.

In one or more embodiments of the present disclosure, a bottom layer of the second electrode is the metal reflective layer.

In one or more embodiments of the present disclosure, the metal reflective layer includes one or more of Ag, Ni, Al, Rh, Pd, Ir, Ru, Mg, Zn, Pt, and Au.

In one or more embodiments of the present disclosure, the transparent conductive layer includes a metal thin film or a metal oxide layer.

In one or more embodiments of the present disclosure, the metal thin film includes one or more of gold, silver, platinum, copper, aluminum, chromium, and palladium.

In one or more embodiments of the present disclosure, the metal oxide layer includes one or more of indium oxide, indium tin oxide, zirconium oxide, cadmium oxide, and titanium nitride. One or more embodiments of the present disclosure further provide a high-voltage LED chip that electrically interconnects adjacent LED light-emitting units according to any one of the above via bridging electrodes. An insulating layer is further disposed in the trenches, and the bridging electrode connects two adjacent LED light-emitting units by being stacked on the insulating layer.

One or more embodiments of the present disclosure further provide a light-emitting device. The light-emitting device includes a light-emitting diode employing the LED chip according to any one of the above embodiments.

One or more embodiments of the present disclosure further provide another light-emitting device. The light-emitting device includes a light-emitting diode employing the high-voltage LED chip described above.

### Embodiment 1

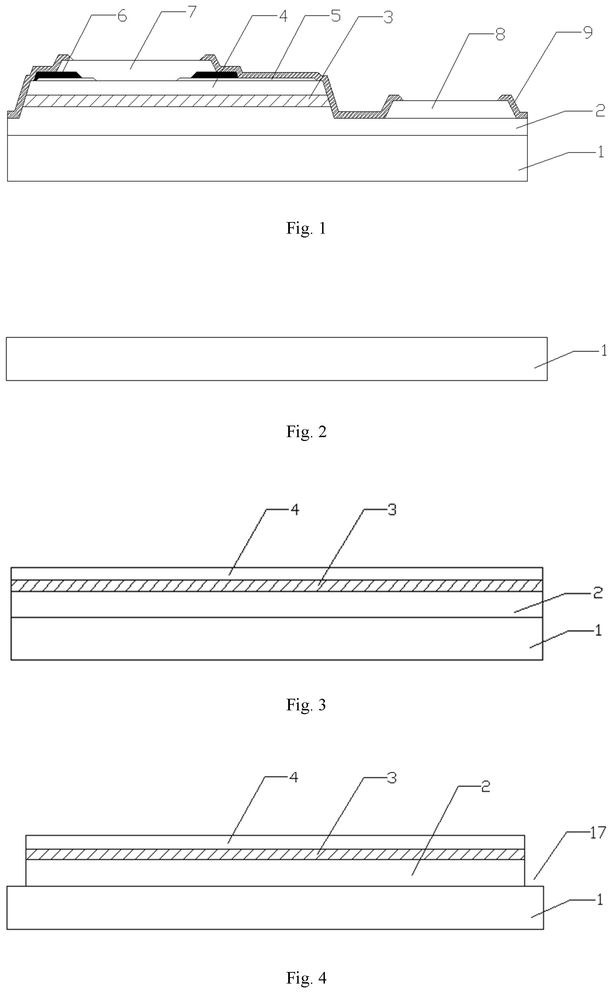

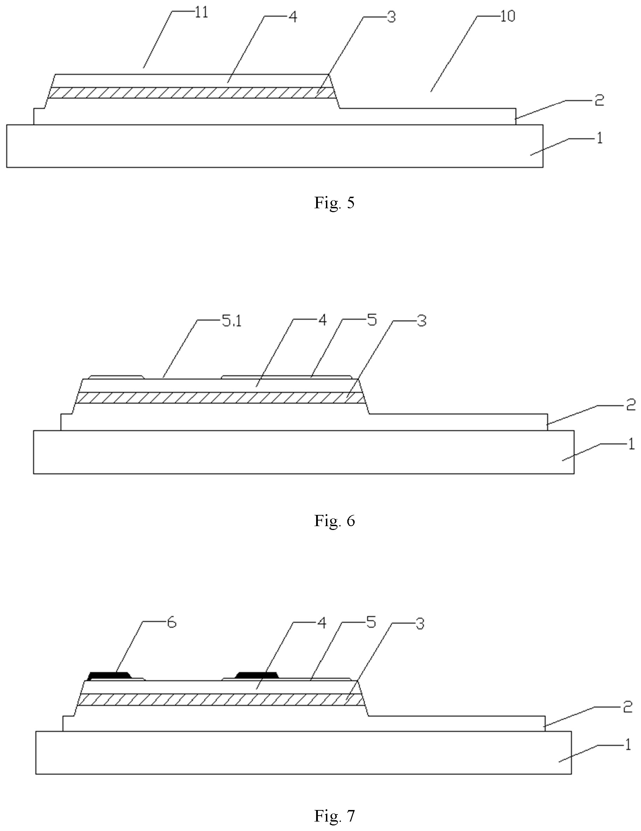

A LED chip includes a substrate 1 and a plurality of LED light-emitting units disposed on the surface of the substrate 1 and isolated from one another by trenches. As shown in FIG. 1, each LED light-emitting unit includes:
an epitaxial stack disposed on the surface of the substrate 1, the epitaxial stack including, stacked in sequence along a first direction, a first conductivity-type semiconductor layer 2, an active region 3, and a second conductivity-type semiconductor layer 4, wherein a local region of the epitaxial stack is etched at least to the first conductivity-type semiconductor layer 2 to define a recess 10 and a light-emitting mesa 11 (refer to FIG. 5 of Embodiment 2 for the manufacturing step), and wherein the first direction is perpendicular to the surface of the substrate 1 and extends from the substrate 1 toward the epitaxial stack;
a transparent conductive layer 5 disposed on the light-emitting mesa 11 and having a second opening 5.1 exposing a portion of the second conductivity-type semiconductor layer 4;
a first insulating layer 6 disposed on a surface of the transparent conductive layer 5 opposite to the epitaxial stack;
a first electrode 8 disposed on a portion of a surface of the recess 10 and spaced apart from the light-emitting mesa 11;
a second electrode 7 extending through the second opening 5.1 to contact a portion of a surface of the first insulating layer 6; and
a second insulating layer 9 disposed on a surface of the epitaxial stack and exposing at least portions of surfaces of the second electrode 7 and the first electrode 8. Further, the second insulating layer 9 covers the light-emitting mesa and the recess and exposes portions of the surfaces of the second electrode 7 and the first electrode 8.

The type of substrate 1 is not limited in the LED chip of this embodiment. For example, the substrate 1 may be, but is not limited to, a sapphire substrate, a silicon substrate, or the like. Additionally, the types of the first conductivity-type semiconductor layer 2, the active region 3, and the second conductivity-type semiconductor layer 4 of the epitaxial stack are also not limited in the LED chip of this embodiment. In embodiments of the present disclosure, the first conductivity-type semiconductor layer 2 may be an N-type semiconductor layer, and correspondingly, the second conductivity-type semiconductor layer 4 may be a P-type semiconductor layer. For instance, the first conductivity-type semiconductor layer 2 may be, but is not limited to, an N-type gallium nitride layer, and correspondingly, the second conductivity-type semiconductor layer 4 may be, but is not limited to, a P-type gallium nitride layer.

In order to highlight the technical features of the present disclosure, the drawing only schematically shows one epitaxial stack unit. In practical product applications, it may include thousands or tens of thousands of epitaxial stack units, depending on the application of the LED chip product, which is not limited herein.

In one or more embodiments of the present disclosure, the first insulating layer 6 exposes a portion of the transparent conductive layer 5 to form a step, and the second electrode 7 extends to the surface of the first insulating layer 6 via the step.

In one or more embodiments of the present disclosure, a projection of the second electrode 7 on the transparent conductive layer 5 and a projection of the second electrode 7 on the first insulating layer 6 have an overlapping region with an area Sa, and a projection area of the second electrode 7 on the transparent conductive layer 5 is S1, such that 0<Sa≤S1/2.

In one or more embodiments of the present disclosure, the step is disposed around an edge of the second opening 5.1.

In one or more embodiments of the present disclosure, the transparent conductive layer 5 covers at least 80% of the area of the light-emitting mesa 11 excluding the second opening 5.1. Further, an edge of the transparent conductive layer 5 is located inward from an edge of the second conductivity-type semiconductor layer 4, with a distance d between them. This distance d is not greater than 2.5 µm. In one or more embodiments of the present disclosure, the distance d is not greater than 1.5 µm, for example, 1 µm. By reducing the distance from the edge of the transparent conductive layer 5 to the edge of the second conductivity-type semiconductor layer 4, the area of the transparent conductive layer 5 is increased, thereby increasing the area of the light-emitting region and achieving further enhancement of the LED's brightness.

In one or more embodiments of the present disclosure, the second insulating layer 9 covers the light-emitting mesa and the recess while being retained on an exposed surface of the first conductivity-type semiconductor layer 2, and exposes portions of the surfaces of the second electrode 7 and the first electrode 8.

In one or more embodiments of the present disclosure, the second electrode 7 has a metal reflective layer.

In one or more embodiments of the present disclosure, a bottom layer of the second electrode 7 is the metal reflective layer.

In one or more embodiments of the present disclosure, the metal reflective layer includes one or more of Ag, Ni, Al, Rh, Pd, Ir, Ru, Mg, Zn, Pt, and Au.

In one or more embodiments of the present disclosure, the transparent conductive layer 5 includes a metal thin film or a metal oxide layer.

In one or more embodiments of the present disclosure, the metal thin film includes one or more of gold, silver, platinum, copper, aluminum, chromium, and palladium.

In one or more embodiments of the present disclosure, the metal oxide layer includes one or more of indium oxide, indium tin oxide, zirconium oxide, cadmium oxide, and titanium nitride. In one or more embodiments of the present disclosure, the second insulating layer 9 includes, but is not limited to, one or more of silicon oxide and magnesium fluoride.

According to the LED chip provided by embodiments of the present disclosure, by arranging: the epitaxial stack including the first conductivity-type semiconductor layer 2, the active region 3, and the second conductivity-type semiconductor layer 4 stacked in sequence along the first direction; the local region of the epitaxial stack being etched at least to the first conductivity-type semiconductor layer 2 to form the recess 10 and the light-emitting mesa 11; the transparent conductive layer 5 stacked on the light-emitting mesa 11 and having the second opening 5.1 exposing a portion of the second conductivity-type semiconductor layer 4; the first insulating layer 6 formed on the surface of the transparent conductive layer 5 opposite to the epitaxial stack; the first electrode 8 stacked on a portion of the surface of the recess 10 and spaced apart from the light-emitting mesa 11; the second electrode 7 extending through the second opening 5.1 to contact a portion of the surface of the first insulating layer 6; and the second insulating layer 9 disposed on the surface of the epitaxial stack and exposing at least portions of the surfaces of the second electrode 7 and the first electrode 8 - a composite region is formed among the first insulating layer 6, the transparent conductive layer 5, the second insulating layer 9, and the second electrode 7. Thereby, an ODR structure is formed through the inter-structural relationships among the transparent conductive layer 5, the first insulating layer 6, the second electrode 7, and the second insulating layer 9. Light can undergo total internal reflection in this composite region, so that light corresponding to the composite region under the second electrode 7 is reflected and extracted from the upper surface of the LED chip, thereby effectively enhancing light extraction efficiency. Simultaneously, since the second insulating layer 9 is disposed on the surface of the epitaxial stack and on portions of the surfaces of the second electrode 7/first electrode 8, at the edge of the second electrode 7 the first insulating layer 6 and the second insulating layer 9 extending in different directions can form a connecting structure with an angle. This can effectively alleviate the diffusion of tensile stress generated in the LED chip under special environments (such as high temperature and high pressure), thereby reducing the risk of functional dielectric layers (such as the transparent conductive layer 5, insulating layers, etc.) being damaged or cracked during bonding, which would affect the reliability of the LED chip. Moreover, the dual protection provided by the first insulating layer 6 and the second insulating layer 9 enhances the moisture resistance capability of the LED chip. By further arranging the first insulating layer 6 to expose a portion of the transparent conductive layer 5 to form a step, and the second electrode 7 extending to the surface of the first insulating layer 6 via the step: the electrode contact area is increased through the step, thereby dispersing stress and reducing the risk of local failure.

By arranging that a projection of the second electrode 7 on the transparent conductive layer 5 and a projection of the second electrode 7 on the first insulating layer 6 have an overlapping region with an area Sa, and a projection area of the second electrode 7 on the transparent conductive layer 5 is S1, such that 0<Sa≤S1/2: the contact area between the second electrode 7 and the transparent conductive layer 5 is ensured to reduce contact resistance, while the size of the composite region area is ensured to improve the ODR reflection effect.

### Embodiment 2

One or more embodiments of the present disclosure provide a method for manufacturing the LED chip according to Embodiment 1. The manufacturing method includes the following steps: S01: As shown in FIG. 2, provide a substrate 1. The type of substrate 1 is not limited in the LED chip of this embodiment. For example, the substrate 1 may be, but is not limited to, a sapphire substrate, a silicon substrate.

S02: As shown in FIG. 3, grow an epitaxial stack. The epitaxial stack includes, stacked in sequence along a first direction, a first conductivity-type semiconductor layer 2, an active region 3, and a second conductivity-type semiconductor layer 4. The first direction is perpendicular to the surface of the substrate 1 and extends from the substrate 1 toward the epitaxial stack. In one or more embodiments of the present disclosure, the first conductivity-type semiconductor layer 2 may be an N-type semiconductor layer, and correspondingly, the second conductivity-type semiconductor layer 4 may be a P-type semiconductor layer. For instance, the first conductivity-type semiconductor layer 2 may be, but is not limited to, an N-type gallium nitride layer, and correspondingly, the second conductivity-type semiconductor layer 4 may be, but is not limited to, a P-type gallium nitride layer.

S03: As shown in FIG. 4, perform deep etching on the epitaxial stack to expose the surface of the substrate 1, forming a plurality of mutually independent epitaxial stack units separated by trenches. In one or more embodiments, the deep etching uses an Inductively Coupled Plasma (ICP) process with etching gases including Cl₂, Ar, and O₂, although the present disclosure is not limited thereto and depends on the specific situation. In order to highlight the technical features of the present disclosure, the drawings schematically show only one epitaxial stack unit; in practical product applications, it may include thousands or tens of thousands of epitaxial stack units, depending on the application of the LED chip product, which is not limited herein. S04: As shown in FIG. 5, etch each of the epitaxial stack units to partially expose the first conductivity-type semiconductor layer 2, thereby forming a recess 10 and a light-emitting mesa 11. In one or more embodiments, the etching uses an ICP process with etching gases including Cl₂, Ar, and O₂, although the present disclosure is not limited thereto and depends on the specific situation. In one or more embodiments, the recess is disposed at a first end of the LED chip. In one or more embodiments, the exposed surface of the first conductivity-type semiconductor layer is disposed surrounding the periphery of the light-emitting mesa 11.

S05: As shown in FIG. 6, manufacture a transparent conductive layer 5 on the light-emitting mesa 11, wherein the transparent conductive layer 5 has a second opening 5.1 exposing a portion of the second conductivity-type semiconductor layer 4. In one or more embodiments, the transparent conductive layer 5 covers at least 80% of the area of the light-emitting mesa 11 excluding the second opening 5.1. Further, an edge of the transparent conductive layer 5 is located inward from an edge of the second conductivity-type semiconductor layer 4, with a distance d not greater than 2.5 µm, preferably not greater than 1.5 µm, for example 1 µm, by which the area of the transparent conductive layer 5 is increased, thereby increasing the area of the light-emitting region and achieving further enhancement of the LED's brightness. In one or more embodiments, the transparent conductive layer 5 includes a metal thin film or a metal oxide layer. The metal thin film includes one or more of gold, silver, platinum, copper, aluminum, chromium, and palladium. The metal oxide layer includes one or more of indium oxide, indium tin oxide, zirconium oxide, cadmium oxide, and titanium nitride.

S06: Deposit a transparent dielectric layer covering exposed surfaces of each epitaxial stack unit. Subsequently, apply a photoresist on the surface of the transparent dielectric layer and use a mask and etching process to obtain the transparent dielectric layer located on the surface of the transparent conductive layer 5, thereby forming the first insulating layer 6 as shown in FIG. 7. In one or more embodiments, the transparent dielectric layer includes one or more of silicon oxide, titanium oxide, silicon nitride, aluminum oxide, magnesium fluoride, spin-on glass (SOG), and polymer. In one or more embodiments, the first insulating layer 6 exposes a portion of the transparent conductive layer 5 to form a step. In one or more embodiments, the step is disposed around an edge of the second opening 5.1.

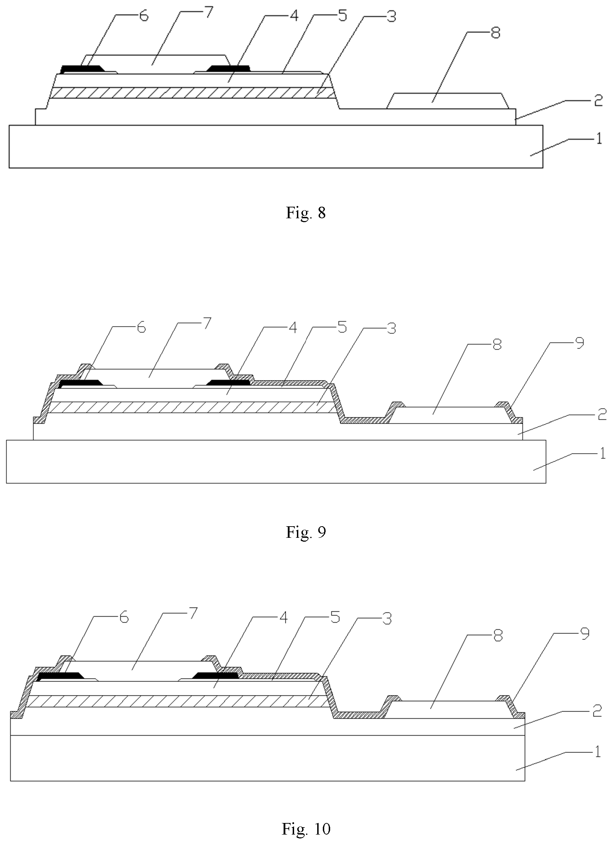

S07: As shown in FIG. 8, manufacture the first electrode 8 and the second electrode 7. The first electrode 8 is disposed on a portion of a surface of the recess 10 and spaced apart from the light-emitting mesa 11. The second electrode 7 extends through the second opening 5.1 to contact a portion of a surface of the first insulating layer 6. Further, the second electrode 7 extends to the surface of the first insulating layer 6 via the step. In one or more embodiments, a projection of the second electrode 7 on the transparent conductive layer 5 and a projection of the second electrode 7 on the first insulating layer 6 have an overlapping region with an area Sa, and a projection area of the second electrode 7 on the transparent conductive layer 5 is S1, such that 0<Sa≤S1/2. In this embodiment, the first electrode 8 and the second electrode 7 may be metal electrodes made of at least one of nickel, gold, chromium, titanium, platinum, palladium, rhodium, iridium, aluminum, tin, indium, tantalum, copper, cobalt, iron, ruthenium, zirconium, tungsten, and molybdenum, or at least one of alloys or stacks of the above materials. In one or more embodiments, the second electrode 7 has a metal reflective layer. A bottom layer of the second electrode 7 may be the metal reflective layer, which includes one or more of Ag, Ni, Al, Rh, Pd, Ir, Ru, Mg, Zn, Pt, and Au.

S08: As shown in FIG. 9, manufacture a second insulating layer 9, disposed on a surface of the epitaxial stack and exposing at least portions of the surfaces of the second electrode 7 and the first electrode 8. Further, the second insulating layer 9 covers the light-emitting mesa 11 and the recess 10 while being retained on an exposed surface of the first conductivity-type semiconductor layer 2, and exposes portions of the surfaces of the second electrode 7 and the first electrode 8. In one or more embodiments, the second insulating layer 9 includes, but is not limited to, one or more of silicon oxide and magnesium fluoride.

S09: As shown in FIG. 10, perform dicing along the trenches to finally obtain a plurality of LED light-emitting units.

### Embodiment 3

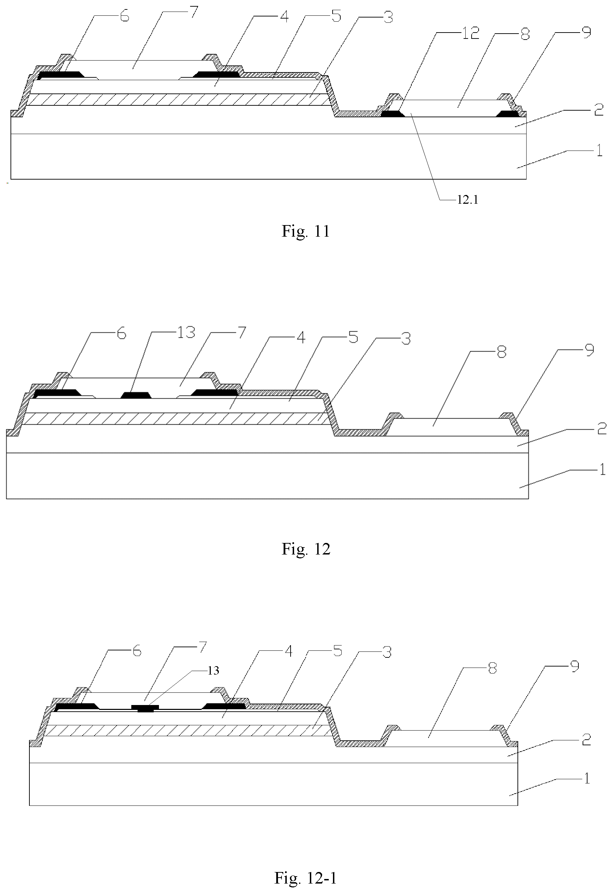

Please refer to FIG. 11, which is a schematic cross-sectional structural view of a LED chip provided according to Embodiment 3 of the present disclosure. Compared to the LED chip of Embodiment 1, the main difference in Embodiment 3 is that a third insulating layer 12 is further disposed on a surface of the recess 10, the third insulating layer 12 having a first opening 12.1 exposing a portion of the first conductivity-type semiconductor layer 2. The first electrode 8 is stacked on a surface of the third insulating layer 12 by being embedded in the first opening 12.1. Thereby, the stability of the first electrode 8 is further improved.

In one or more embodiments of the present disclosure, the first insulating layer 6 and the third insulating layer 12 may be formed simultaneously by using photolithography to etch the transparent dielectric layer in step S06 of Embodiment 2.

### Embodiment 4

Please refer to FIG. 12, which is a schematic cross-sectional structural view of a LED chip provided according to Embodiment 4 of the present disclosure. Compared to the LED chip of Embodiment 1, the main difference in Embodiment 4 is that a current blocking layer 13 is disposed on a bottom surface of the second opening 5.1. Further, the current blocking layer 13 and the transparent conductive layer 5 form a spacing groove, and the second electrode 7 is embedded in the spacing groove to contact the second conductivity-type semiconductor layer 4. This improves current crowding and promotes lateral current spreading. Simultaneously, the inter-structural relationships among the second electrode 7, the first insulating layer 6 (dielectric layer), the spacing groove, the current blocking layer 13 (dielectric layer), and the transparent conductive layer 5 (conductive layer) again form an ODR structure, which is beneficial for increasing the area of the total reflection layer below the second electrode 7, further enhancing reflection efficiency.

In one or more embodiments of the present disclosure, a projection area of the current blocking layer 13 on the transparent conductive layer 5 is S2, and a bottom surface area of the second opening 5.1 is S3, such that 0<S2≤S3/2. Thus, while ensuring current blocking and total reflection effects, the contact area between the second electrode 7 and the second conductivity-type semiconductor layer 4 is ensured to improve the reliability of electrode wire bonding. The specific area of the current blocking layer 13 need only satisfy the above requirements. The shape of the current blocking layer 13 may be trapezoidal, square, or rectangular.

In one or more embodiments of the present disclosure, the first insulating layer 6 and the current blocking layer 13 may be formed simultaneously by using photolithography to etch the transparent dielectric layer in step S06 of Embodiment 2.

### Embodiment 4-1

Please refer to FIG. 12-1, which is a schematic cross-sectional structural view of a LED chip provided according to Embodiment 4-1 of the present disclosure. Compared to the LED chip of Embodiment 1, the main difference in Embodiment 4-1 is that a current blocking layer 13 is provided. The current blocking layer 13 extends through the second opening 5.1 to contact a top surface of the first insulating layer 6. The current blocking layer 13 and the first insulating layer 6 are spaced apart by a spacing groove. The spacing groove between the current blocking layer 13 and the first insulating layer 6 exposes a portion of the transparent conductive layer 5 surrounding the periphery of the current blocking layer 13. The second electrode 7 covers the current blocking layer 13 by being embedded in the spacing groove between the current blocking layer 13 and the first insulating layer 6, and extends to the surface of the first insulating layer 6, so that it has a composite region with the transparent conductive layer 5 and the first insulating layer 6 along the first direction. With this arrangement, an ODR structure is formed through the inter-structural relationships among the second electrode 7 (metal reflector), the first insulating layer 6 (dielectric layer), the spacing groove, the current blocking layer 13 (dielectric layer), and the transparent conductive layer 5 (conductive layer). Light can undergo total internal reflection in the composite region of the second electrode 7 with the transparent conductive layer 5 and the first insulating layer 6, so that light corresponding to this composite region under the second electrode 7 is reflected and extracted from the upper surface of the LED chip, thereby effectively enhancing light extraction efficiency. Simultaneously, the current blocking layer 13 disposed directly below the second electrode 7 can effectively prevent current crowding caused by the current injected from the second electrode 7 (P-type electrode) of the LED chip concentrating directly under the electrode.

In one or more embodiments of the present disclosure, an area of the composite region of the second electrode 7 with the transparent conductive layer 5 and the first insulating layer 6 is S10, and an area of the bottom surface of the second opening 5.1 is S3, such that 0.5×S10≤S3≤3×S10. Thus, while ensuring the contact area between the second electrode 7 and the transparent conductive layer 5 to reduce contact resistance, the area size of the composite region is ensured to improve the ODR reflection effect.

In one or more embodiments of the present disclosure, the first insulating layer 6 and the current blocking layer 13 may be formed simultaneously by using photolithography to etch the transparent dielectric layer in step S06 of Embodiment 2.

### Embodiment 5

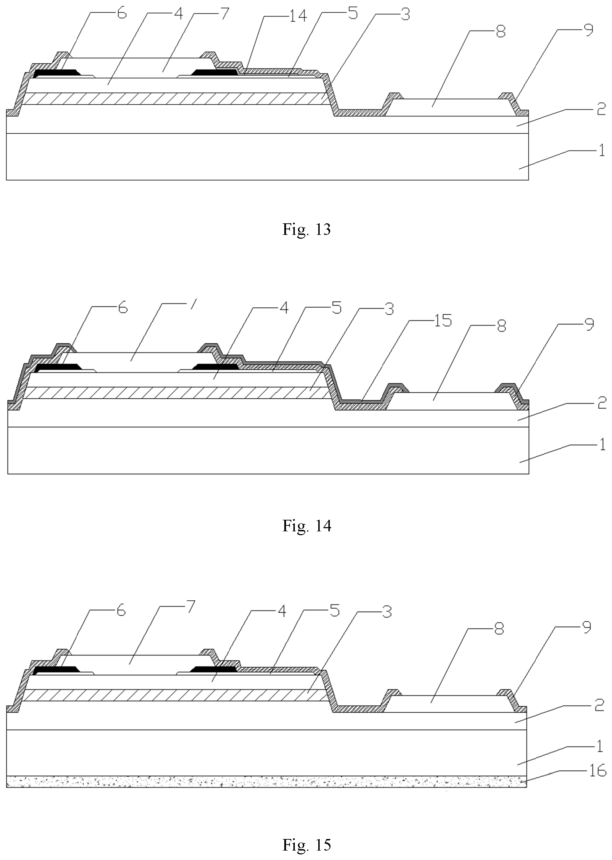

Please refer to FIG. 13, which is a schematic cross-sectional structural view of a LED chip provided according to Embodiment 5 of the present disclosure. Compared to the LED chip of Embodiment 1, the main difference in Embodiment 5 is that: the first electrode 8 includes a first electrode pad disposed at a first end of the LED chip. The second opening 5.1 is formed at a second end of the LED chip. The second electrode 7 includes a second electrode pad and at least one electrode extension strip 14 connected to the second electrode pad, wherein the second electrode pad extends through the second opening 5.1 to contact a top surface of the first insulating layer 6, and the electrode extension strip 14 extends from the second electrode pad toward the second end of the LED chip. Thereby, current can be better guided and spread through the electrode extension strip 14, avoiding current crowding. The material, shape, and structure of the electrode extension strip 14 need only meet the requirements for electrode extension and current guidance.

In one or more embodiments of the present disclosure, the first electrode 8 may also include an electrode extension strip connected to the first electrode pad and extending toward the first end. In one or more embodiments of the present disclosure, at least a portion of the electrode extension strip 14 is in contact with the transparent conductive layer 5.

In one or more embodiments of the present disclosure, the electrode extension strip 14 has a forked structure, and the forked structure contacts the transparent conductive layer 5 by penetrating through the first insulating layer 6. Alternatively, the transparent conductive layer 5 has through-holes, and the electrode extension strip 14 has forked fingers, the forked fingers being formed and held in the through-holes of the transparent conductive layer 5.

It should be emphasized that, in other embodiments, a combination of Embodiment 5 and Embodiment 4 may be used, which is not elaborated herein.

### Embodiment 6

Please refer to FIG. 14, which is a schematic cross-sectional structural view of a LED chip provided according to Embodiment 6 of the present disclosure. Compared to the LED chip of Embodiment 1, the main difference in Embodiment 6 is that the LED chip further includes a refractive-index matching layer 15 disposed on a surface of the second insulating layer 9 opposite to the epitaxial stack and forming a graded-index structure with the second insulating layer 9, further enhancing light extraction efficiency. In one or more embodiments, a refractive index of the refractive-index matching layer 15 is not less than a refractive index of the second insulating layer 9. Further, the first insulating layer 6 or the second insulating layer 9 may include a layered structure composed of one or more of SiO₂ and MgF₂, and the refractive-index matching layer 15 may include a layered structure composed of one or more of TiO₂, Si₃N₄, and Al₂O₃. In one or more embodiments of the present disclosure, the second insulating layer 9 is a SiO₂ layer, and the refractive-index matching layer 15 is an Al₂O₃ layer. Benefiting from the excellent passivation properties of Al₂O₃, it can effectively cover dangling bonds and defect states on the SiO₂ surface, reducing non-radiative recombination of carriers at the surface. The reduction in non-radiative recombination directly improves the internal quantum efficiency (IQE), meaning more electrical energy is converted into light energy rather than heat.

### Embodiment 7

Please refer to FIG. 15, which is a schematic cross-sectional structural view of a LED chip provided according to Embodiment 7 of the present disclosure. Compared to the LED chip of Embodiment 1, the main difference in Embodiment 7 is that a reflective layer 16 is further disposed on a surface of the substrate 1 opposite to the epitaxial stack. Further, the reflective layer 16 includes a distributed Bragg reflector (DBR) composed of alternating stacks of high-refractive-index material layers and low-refractive-index material layers. Alternatively, the reflective layer may also be a metal reflective layer. Its material needs to meet the requirements for a DBR or metal reflector.

### Embodiment 8

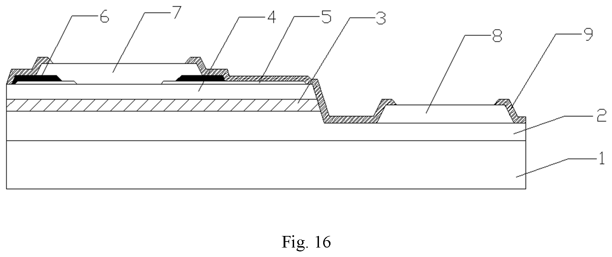

Please refer to FIG. 16, which is a schematic cross-sectional structural view of a LED chip provided according to Embodiment 8 of the present disclosure. Compared to the LED chip of Embodiment 1, the main difference in Embodiment 8 is that the exposed surface of the first conductivity-type semiconductor layer is disposed only in the recess and does not surround the periphery of the light-emitting mesa 11. Therefore, in this case, the second insulating layer 9 does not completely cover the epitaxial stack.

In practical applications, any combination of two or more of the above embodiments may be employed, depending on the specific technical requirements of the product. The present disclosure does not limit the same.

Furthermore, the LED chip provided by each of the above embodiments is also applicable to a high-voltage LED chip. The high-voltage LED chip electrically interconnects adjacent LED light-emitting units according to any one of the above via bridging electrodes. An insulating layer is further disposed in the trenches, and the bridging electrode connects two adjacent LED light-emitting units by being stacked on the insulating layer. The specific structure, performance, and advantages thereof may be referred to in the foregoing description and are not elaborated herein.

In addition, one or more embodiments of the present disclosure further provide a light-emitting device. The light-emitting device includes a light-emitting diode employing the LED chip or the high-voltage LED chip provided by any of the above embodiments. The specific performance and advantages thereof may be referred to in the foregoing description and are not elaborated herein.

It should further be noted that, in this specification, relational terms such as "first" and "second" are used solely to distinguish one entity or operation from another, and do not necessarily require or imply any actual relationship or sequence between such entities or operations. Furthermore, the terms "include," "comprise," or any other variations thereof are intended to cover non-exclusive inclusion, such that an article or device including a set of elements includes not only those elements but also other elements not explicitly listed, or elements inherent to such article or device. Without further limitation, an element defined by the phrase "includes a ..." does not exclude the existence of additional identical elements in the article or device including the above elements.

The above descriptions of the disclosed embodiments enable those skilled in the art to implement or use the present application. Various modifications to these embodiments will be apparent to those skilled in the art, and the general principles defined herein may be implemented in other embodiments without departing from the spirit or scope of the present application. Accordingly, the present application is not intended to be limited to the embodiments shown herein, but is to be accorded the widest scope consistent with the principles and novel features disclosed herein.

## Claims

1. A LED chip comprising a substrate and a plurality of LED light-emitting units disposed on a surface of the substrate and isolated from one another by trenches, wherein each LED light-emitting unit comprises:
an epitaxial stack disposed on the surface of the substrate, the epitaxial stack comprising, in sequence along a first direction, a first conductivity-type semiconductor layer, an active region, and a second conductivity-type semiconductor layer, wherein a local region of the epitaxial stack is etched at least to the first conductivity-type semiconductor layer to define a recess and a light-emitting mesa, and wherein the first direction is perpendicular to the surface of the substrate and extends from the substrate toward the epitaxial stack;
a transparent conductive layer disposed on the light-emitting mesa and having a second opening exposing a portion of the second conductivity-type semiconductor layer;
a first insulating layer disposed on a surface of the transparent conductive layer opposite to the epitaxial stack;
a first electrode disposed on a portion of a surface of the recess and spaced apart from the light-emitting mesa;
a second electrode extending through the second opening to contact a portion of a surface of the first insulating layer; and
a second insulating layer disposed on a surface of the epitaxial stack and exposing at least portions of surfaces of the second electrode and the first electrode.

2. The LED chip of claim 1, wherein the first insulating layer exposes a portion of the transparent conductive layer to form a step, and the second electrode extends to the surface of the first insulating layer via the step.

3. The LED chip of claim 1, wherein a projection of the second electrode on the transparent conductive layer and a projection of the second electrode on the first insulating layer have an overlapping region with an area Sa, and a projection area of the second electrode on the transparent conductive layer is S1, such that 0 < Sa ≤ S1/2.

4. The LED chip of claim 2, wherein the step is disposed around an edge of the second opening.

5. The LED chip of claim 1, wherein a current blocking layer is disposed on a bottom surface of the second opening.

6. The LED chip of claim 5, wherein the current blocking layer and the transparent conductive layer form a spacing groove, and the second electrode is embedded in the spacing groove to contact the second conductivity-type semiconductor layer.

7. The LED chip of claim 6, wherein a projection area of the current blocking layer on the transparent conductive layer is S2, and a bottom surface area of the second opening is S3, such that 0 < S2 ≤ S3/2.

8. The LED chip of claim 7, wherein the first insulating layer and the current blocking layer are formed simultaneously by photolithography of a transparent dielectric layer.

9. The LED chip of claim 3, wherein the transparent dielectric layer comprises one or more of silicon oxide, silicon nitride, aluminum oxide, and magnesium fluoride.

10. The LED chip of claim 1, wherein a third insulating layer is further disposed on a surface of the recess, the third insulating layer having a first opening exposing a portion of the first conductivity-type semiconductor layer, and the first electrode is stacked on a surface of the third insulating layer by being embedded in the first opening.

11. The LED chip of claim 10, wherein the first insulating layer and the third insulating layer are formed simultaneously by photolithography of a transparent dielectric layer.

12. The LED chip of claim 1, further comprising a refractive-index matching layer disposed on a surface of the second insulating layer opposite to the epitaxial stack and forming a graded-index structure with the second insulating layer, wherein a refractive index of the refractive-index matching layer is not less than a refractive index of the second insulating layer.

13. The LED chip of claim 1, wherein a reflective layer is further disposed on a surface of the substrate opposite to the epitaxial stack.

14. The LED chip of claim 1, wherein the first electrode comprises a first electrode pad disposed at a first end of the LED chip, and wherein the second opening is formed at a second end of the LED chip; and wherein the second electrode comprises a second electrode pad and at least one electrode extension strip connected to the second electrode pad, the second electrode pad extending through the second opening to contact a top surface of the first insulating layer, and the electrode extension strip extending from the second electrode pad toward the second end of the LED chip.

15. The LED chip of claim 14, wherein at least a portion of the electrode extension strip is in contact with the transparent conductive layer.

16. The LED chip of claim 18, wherein the electrode extension strip has a forked structure, and the forked structure contacts the transparent conductive layer by penetrating through the first insulating layer.

17. The LED chip of claim 1, wherein the second insulating layer covers the light-emitting mesa and the recess while being retained on an exposed surface of the first conductivity-type semiconductor layer.

18. A high-voltage LED chip comprising a plurality of LED light-emitting units according to any one of claims 1 to 17, wherein adjacent LED light-emitting units are electrically interconnected via bridging electrodes, an insulating layer is disposed in the trenches, and the bridging electrode connects two adjacent LED light-emitting units by being stacked on the insulating layer.

19. A light-emitting device comprising a light-emitting diode employing the LED chip according to any one of claims 1 to 17.

20. A light-emitting device comprising a light-emitting diode employing the high-voltage LED chip according to claim 18.
